(19) **Europäisches Patentamt**

**European Patent Office**

**Office européen des brevets**

(11) **EP 1 070 768 B1**

(12) **EUROPÄISCHE PATENTSCHRIFT**

(45) Veröffentlichungstag und Bekanntmachung des Hinweises auf die Patenterteilung:
**04.05.2005 Patentblatt 2005/18**

(51) Int Cl.⁷: **C23C 14/48**, H01L 21/3115

(21) Anmeldenummer: **00114817.0**

(22) Anmeldetag: **11.07.2000**

(54) **Verfahren zur Herstellung von Monolagen aus Silizium-Nanoclustern in Siliziumdioxid**

Method for making silicon nanocluster monolayers in silicon oxide

Procédé de fabrication d'une couche monomoleculaire de nanoclusters de silicium dans une couche de silice

(84) Benannte Vertragsstaaten:
**AT BE CH CY DE DK ES FI FR GB GR IE IT LI LU MC NL PT SE**

(30) Priorität: **17.07.1999 DE 19933632**

(43) Veröffentlichungstag der Anmeldung:
**24.01.2001 Patentblatt 2001/04**

(73) Patentinhaber: **Forschungszentrum Rossendorf e.V.**
**01328 Dresden (DE)**

(72) Erfinder:
• **Schmidt, Bernd, Dr.**
**01187 Dresden (DE)**
• **Heinig, Karl-Heinz, Dr.**
**01237 Dresden (DE)**

(56) Entgegenhaltungen:
• **BORODIN V A ET AL: "Modeling of Ge nanocluster evolution in ion-implanted SiO2 layer" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, Bd. 147, Nr. 1-4, Januar 1999 (1999-01), Seiten 286-291, XP004158489 ISSN: 0168-583X**
• **VON BORANY J ET AL: "The formation of narrow nanocluster bands in Ge-implanted SiO2-layers" SOLID STATE ELECTRONICS,GB,ELSEVIER SCIENCE PUBLISHERS, BARKING, Bd. 43, Nr. 6, Juni 1999 (1999-06), Seiten 1159-1163, XP004169357 ISSN: 0038-1101**
• **MARKWITZ A ET AL: "Microstructural investigation of ion beam synthesised germanium nanoclusters embedded in SiO2 layers" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, Bd. 142, Nr. 3, Juli 1998 (1998-07), Seiten 338-348, XP004148819 ISSN: 0168-583X**

EP 1 070 768 B1

**Beschreibung**

Die Erfindung bezieht sich auf ein Verfahren zur Herstellung von sehr dünnen Monolagen aus Silizium-Nanoclustern in Siliziumdioxid in sehr kleinem Abstand von der Siliziumdioxid/Silizium-Grenzfläche. Die Anwendung des Verfahrens ist besonders für mikroelektronische Speicherbauelemente gegeben.

Für die Halbleiterelektronik wird der Einsatz von Verfahren zur Herstellung von Nanostrukturen zunehmend diskutiert. So werden in Speicherschaltkreisen- und Logikschaltkreisen auf Siliziumbasis die Siliziumdioxidschicht ($SiO_2$-Schicht) des Gate (Gate-Oxid) und die Diffusionsbarrieren nur noch wenige Nanometer dick sein [Semiconductor Industry Association, USA: The National Technology Roadmap for Semiconductors, (1997)]. Einzelelektronen-Transistoren, die den Strom nur aufgrund eines einzigen gespeicherten oder nicht gespeicherten Elektrons schalten, basieren ebenfalls auf wenige Nanometer großen Clustern. Solche neuartigen Transistor-Konzeptionen kommen für den Betrieb bei Raumtemperatur nur deswegen in Frage, weil wegen der Kleinheit der Nanocluster einzelne getrappte Elektronen eine elektrostatische Energie besitzen, die deutlich größer als das thermisches Rauschen ist.

Für elektrisch geladene Nanocluster in einem Dielektrikum wächst die elektrostatische Energie umgekehrt proportional mit der Clustergröße. Bei Clustergrößen von etwa 5 nm reicht daher schon die Beladung mit einem Elektron zur sicheren Informationsspeicherung bei Raumtemperatur [ S. Tawari, F. Rana, H. Hanafi, A. Hartstein, E.F. Crabbe, K. Chan, Appl. Phys. Lett. 68 (1996),1377]. Bisher ist ein gut kontrollierbares und hinreichend reproduzierbares Verfahren zur Herstellung von Nanocluster-Monolagen für höchstintegrierte Schaltkreise sowie für Einzelektronen-Transistoren nicht bekannt. Die erprobten oder sich in Untersuchung befindlichen Verfahren sind die Ionenstrahlsynthese von Nanoclustern in $SiO_2$-Schichten, die chemische Abscheidung von Nanocluster-haltigen $SiO_2$-Schichten aus der Dampfphase (CVD-Verfahren) und die Abscheidung derartiger Schichten durch Kathodenzerstäubung (Sputter-Verfahren).

Bei der Ionenstrahlsynthese [M. Hao, H. Hwang, J.C. Lee, Soli-State Electronics, 36 (1993) 1321] werden Si- Nanocluster durch Implantation von Siliziumionen in eine $SiO_2$-Schicht ($d_{ox} \sim 20...50$ nm) auf einem Siliziumsubstrat erzeugt. Der sich anschließende Temperschritt dient dem Wachstum der Cluster und gleichzeitig zur Ausheilung der implantationsbedingten Strahlenschäden in der $SiO_2$-Schicht und ggf. auch im Substrat. Weiterhin wurde gezeigt, daß bei geeigneter Ionenimplantation von Germanium eine dünne Lage von Nanoclustern an der $SiO_2$/Si-Grenzfläche erzeugt werden kann [J. von Borany, R. Grötzschel, K.H. Heinig, A. Markwitz, B. Schmidt, W. Skorupa, E-MRS Spring Meeting, Symp. N: Material and Processes for Submicron Technologies, Strasbourg, France, June 16-19, 1998]. Neben den sich einstellenden Nanoclusterlagen an der Si/$SiO_2$-Grenzfläche entstehen hierbei weitere störende Nanocluster in anderen Bereichen der $SiO_2$-Schicht.

Beim CVD-Verfahren [S. Tiwari, F. Rana, H. Hanafi, A. Hartstein, E.F. Crabbe, K. Chan, Appl. Phys. Lett., 68 (1996) 1377] wird eine $SiO_2$-Schicht mit einer Überschußkonzentration von Silizium in einem komplizierten Mehrschrittverfahren auf ein dünnes thermisches Oxid (Tunneloxid, $d_{ox} = 2...5$ nm) unter Verwendung von Silan ($SiH_4$) bei einer Temperatur von 500 bis 600 °C mit jeweils zwischenzeitlicher Oxydation zur Separation der Silizium-Cluster abgeschieden. Die Herstellung der kompletten $SiO_2$-Schicht wird mit der Abscheidung einer dünnen amorphen Silizium-Schicht und deren Aufoxydation abgeschlossen.

Bei der Abscheidung durch Kathodenzerstäubung [H. Seifarth, R. Grötzschel, A. Markwitz, W. Matz, P. Nitzsche, L. Rebohle, Thin Solid Films, 330 (1998) 202] wird ebenfalls auf thermisch gewachsenes Tunneloxid eine 2 bis 5 nm dicke $SiO_2$-Schicht mit einer Überschußkonzentration von Silizium und darüber anschließend eine stöchiometrische $SiO_2$-Schicht entsprechender Dicke abgeschieden. Die Formierung der Silizium-Clusterschicht wird in einem nachfolgenden Temperschritt durchgeführt.

Alle genannten Verfahren zur Nanoclustersynthese sind dadurch gekennzeichnet, daß in die $SiO_2$-Schicht immer gezielt eine Konzentration an Clustermaterial eingebracht wird, die über dessen Löslichkeitsgrenze liegt und daß durch die notwendige Temperaturbehandlung in der Regel Clustergrößen mit einer breiten Lifshiz-Slyozov-Wagner(LSW)-Verteilung [I.M. Lifshiz, V.V. Slyozov, J. Phys. Chem Solids, 19 (1961) 35] entstehen. Desweiteren werden mit den Verfahren die üblicherweise sehr dünnen $SiO_2$-Schichten oft negativ beeinflußt und in ihren elektrischen Eigenschaften mehr oder weniger degradiert, was für die Qualität und Funktionsweise von MOS- bzw. CMOS-Bauelementen unerwünscht ist.

Wünschenswert für die Anwendung von Monolagen aus Silizium-Nanoclustern in einer dünnen $SiO_2$-Schicht zur Ladungsträgerspeicherung in MOS-Kapazitäten und MOS-Feldeffekttransistoren ist ein Verfahren, das eine Nanocluster-Monolage mit geringer Breite der Größenverteilung in unmittebarer Nähe der $SiO_2$/Si-Grenzfläche (2...5 nm von der Grenzfläche entfernt) erzeugt, ohne daß durch das Verfahren von außen zusätzliche Elemente in die $SiO_2$-Schicht eingebracht werden müssen. Es ist daher Aufgabe der Erfindung, ein Verfahren zu schaffen, das die Erzeugung von Nanoclustern zur Ladungsträgerspeicherung in konkretem Abstand von der $SiO_2$/Si-Grenzfläche mit idealerweise unimodaler Größenverteilung und in einer Monolage erlaubt und somit eine scharfe Be- und Entladespannung der Silizium-Nanocluster bewirkt.

Erfindungsgemäß wird die Aufgabe dadurch gelöst, daß eine bis zu 100 nm dicke SiO$_2$-Schicht auf einem Siliziumsubstrat mit hochenergetischen Ionen mit einer Ionenenergie von 10 keV bis 10 MeV und einer Ionendosis von 10$^{15}$ bis 10$^{18}$ cm$^{-2}$ bei in der Regel gegenüber Raumtemperatur erhöhter Temperatur der SiO$_2$-Schicht, die jedoch unterhalb einer kritischen Temperatur T$_c$ liegt, durchstrahlt wird und durch Ionenstrahlmischen des grenzflächennahen Bereiches in der SiO$_2$-Schicht eine Lage aus Silizium-Nanoclustern erzeugt wird. Je nach Intensität des Ionenstrahlmischens und der Diffusion von Silizium in der SiO$_2$-Schicht unter Ionenbeschuß liegt T$_c$ im Bereich 300...800 °C. Die Größe der kritischen Temperatur bestimmt sich aus:

$$T_c = \frac{(E_S - E_A)}{k \cdot \ln\left(\dfrac{C_0 \cdot D_0}{q \cdot \lambda^2}\right)}$$

λ bedeutet hierbei den mittleren Weg, um den die Si-Atome des Substrates bei Beteiligung an der Stoßkaskade versetzt werden. λ liegt zwischen 0,2 und 1,0 nm und kann mit Standardprogrammen [z.B. J.F. Ziegler (Ed.), SRIM: The Stopping and Range of Ions in Matter, Program Manual, (1996)] genau bestimmt werden. q ist für gegebene Ionendosis und Ionenenergie die Wahrscheinlichkeit pro Zeiteinheit, daß in einem Einheitsvolumen des Substrates Si-Atome deplatziert werden. q kann ebenfalls mit dem obengenannten Standardprogramm genau berechnet werden. E$_S$ und E$_A$ sowie C$_0$ und D$_0$ sind die üblichen Materialparameter für die Löslichkeit C und Diffusion D der Siliziumatome in der SiO$_2$-Schicht, wobei C und D in Form von Arrheniusgesetzen beschrieben werden:

$$C = C_0 \cdot \exp\left(\frac{-E_S}{kT}\right)$$

$$D = D_0 \cdot \exp\left(\frac{-E_A}{kT}\right)$$

Die Energie der Ionen wird dabei so gewählt, daß der mittlere Ort, an dem die Ionen nach Durchdringen der SiO$_2$-Schicht zur Ruhe kommen, hinreichend weit von der Si/SiO$_2$-Grenzfläche entfernt im Siliziumsubstrat liegt. Vorteilhafterweise wird für die Ionen eine gleiche oder annähernd gleiche Masse wie die Atome des Siliziumsubstrates gewählt, um den wünschenswerten Effekt des Ionenstrahlmischens des Siliziums aus der Oberfläche des Siliziumsubstrates in die SiO$_2$-Schicht zu maximieren und damit die Ionenstrahldosis zu reduzieren bei gleichzeitiger Reduzierung des Ionenstrahl-induzierten Strahlenschadens in der SiO$_2$-Schicht, im Siliziumsubstrat und in evtl. vorhandenen Deckschichten.

Bei geeigneter Wahl einer hinreichend hohen Ionenstromdichte und Ionenenergie kann für die Heizung des Siliziumsubstrates und der SiO$_2$-Schicht die Eigenerhitzung durch den Ionenstrahl ausgenutzt werden und somit auf eine externe Substratheizung verzichtet werden. Die SiO$_2$-Schicht kann durch eine oder mehrere Schichten abgedeckt sein, wenn diese Schichten in ihrer Gesamtheit so dünn sind, daß die hochenergetischen Ionen sowohl die Deckschichte(n) als auch die SiO$_2$-Schicht vollständig durchdringen können.

Die Deckschicht kann eine Siliziumnitridschicht, eine andere chemisch inerte Isolatorschicht oder eine gegenüber Silizium und Sauerstoff chemisch inerte Metallschicht oder aber eine halbleitende amorphe oder polykristalline Siliziumschicht sein. In letzterem Fall wird durch das Ionenstrahlmischen der Grenzfläche zwischen der Deckschicht und der SiO$_2$-Schicht in Nähe dieser Grenzfläche eine zweite Lage aus Silizium-Nanocluster erzeugt.

Der Vorteil des Verfahrens gegenüber dem bisherigen Verfahren der Ionenstrahlsynthese von Silizium-Nanoclustern in SiO$_2$-Schichten besteht darin, daß bei Durchstrahlung der SiO$_2$-Schicht die höchste Konzentration an ioneninduzierten Defekten nicht in der SiO$_2$-Schicht oder in Nähe der SiO$_2$/Si-Grenzfläche, sondern in der sogenannten End-of-Range(EoR)-Tiefe, weit genug von der SiO$_2$/Si-Grenzfläche entfernt, entsteht. Desweiteren ist die Wahl der Größe der Ionenergie wesentlich unkritischer im Vergleich zur Wahl der Ionenenergie bei Implantation der Ionen direkt in die SiO$_2$-Schicht. Bei der Ionenimplantation in die SiO$_2$-Schicht trägt nur ein sehr geringer Teil der implantierten Ionen zum Ionenstrahlmischen des SiO$_2$/Si-Grenzflächenbereiches und somit zur Ausbildung von den gewünschten, grenzflächennahen, Nanoclustern bei, während der Großteil der Ionen ungefähr in die Mitte der SiO$_2$-Schicht implantiert wird und dort eine für die Anwendung nicht erwünschte Bildung von Nanoclustern hervorruft. Bei Implantation von Silizium in SiO$_2$-Schichten mit Schichtdicken von kleiner 10 nm muß desweiteren die Ionenenergie auf Werte um 1 keV oder kleiner gesenkt und mit steigender Genauigkeit eingestellt werden. Dagegen kann bei der erfindungsgemäßen Ionendurchstrahlung die Dicke der SiO$_2$-Schicht in einem Bereich von 5...50 nm schwanken ohne daß die Ionenenergie verändert und somit der konkreten SiO$_2$-Schichtdicke angepaßt werden muß.

Ein weiterer Vorteil des Verfahrens gegenüber allen anderen Verfahren zur Herstellung von Si-Nanocluster-Monolagen in SiO$_2$-Schichten ist, daß durch Nutzung der Ionenstrahl-induzierten Substratheizung bei hohen Ionenstromdichten und Ionenenergien auf den bei allen anderen Verfahren immer notwendigen und der Ionenstrahlsynthese bzw. den Abscheideverfahren folgenden Temperprozeß verzichtet werden kann.

Die Erfindung wird nachstehend an einem Ausführungsbeispiel näher erläutert. In der zugehörigen Zeichnungen zeigt

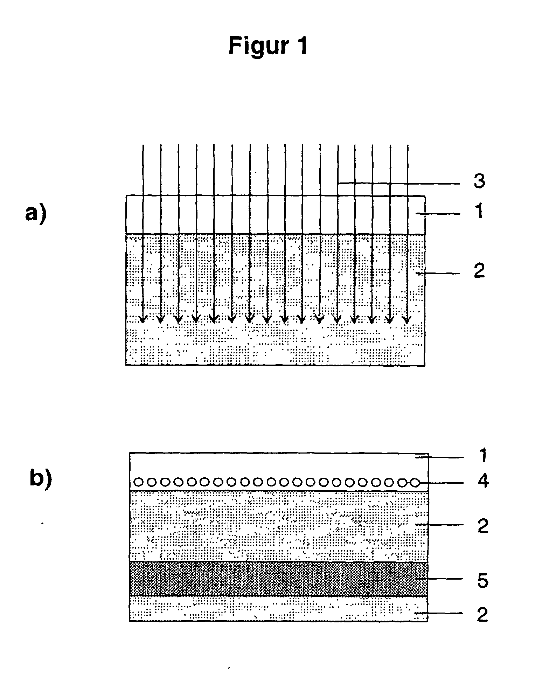

Fig. 1 a    die Durchstrahlung einer $SiO_2$-Schicht auf einem Siliziumsubstrat,

Fig. 1 b    den nach der Durchstrahlung modifizierten Schichtaufbau nach Fig. 1 a,

Fig. 2 a    die Durchstrahlung der mit einer Deckschicht versehenen $SiO_2$-Schicht auf einem Siliziumsubstrat,

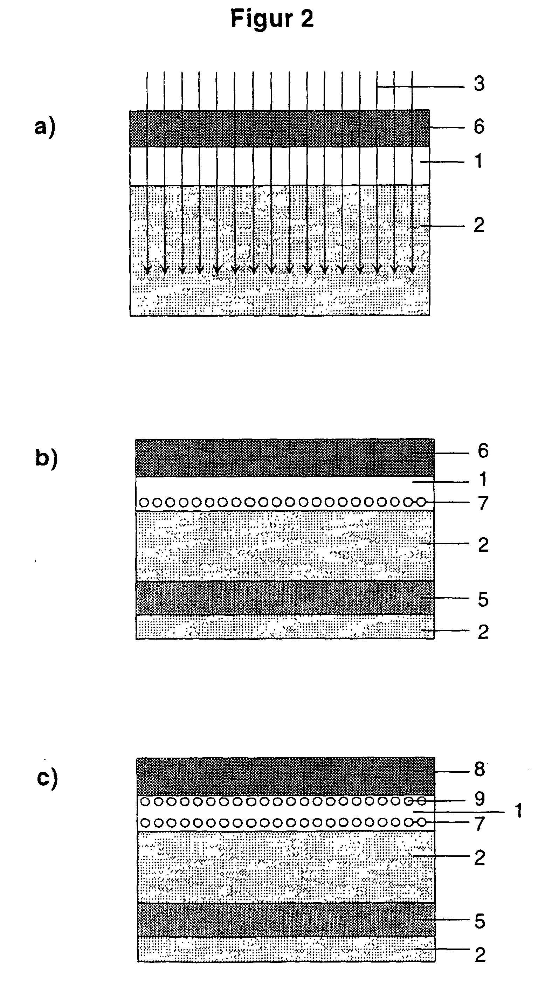

Fig. 2 b    den nach der Durchstrahlung modifizierten Schichtaufbau nach Fig. 2 a mit einer Siliziumnitrid-Deckschicht,

Fig. 2 c    den nach der Durchstrahlung modifizierten Schichtaufbau nach Fig. 2 a mit einer amorphen oder polykristallinen Deckschicht,

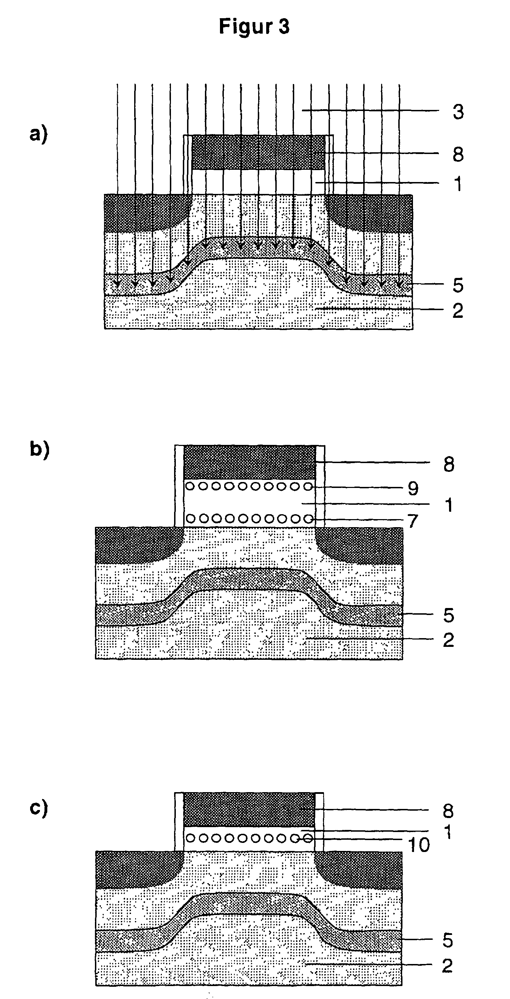

Fig. 3 a    die Durchstrahlung einer MOS-Feldeffekttransistor-Struktur mit einem dünnen Gateoxid und einer poly-Si-Gateelektrode,

Fig. 3 b    die nach der Bestrahlung modifizierte MOS-Feldeffekttransistor-Struktur mit einer Gateoxiddicke > 15 nm,

Fig. 3 c    die nach der Bestrahlung modifizierte MOS-Feldeffekttransistor-Struktur mit einer Gateoxiddicke < 10 nm.

Die $SiO_2$-Schicht 1 auf dem Siliziumsubstrat 2 in Figur 1 wird bei einer $SiO_2$-Schichtdicke von 20 nm bis 100 nm vorzugsweise mit Silizium-Ionen 3 mit einer Energie von 300 keV bis 800 keV und einer Dosis von $(0,1...10,0) \cdot 10^{16}$ cm$^{-2}$ durchstrahlt. Die Temperatur der $SiO_2$-Schicht beträgt während der Ionenbestrahlung 600 bis 800 °C. Dabei wird in einem Abstand von 2 bis 5 nm von der $SiO_2$/Si-Grenzfläche durch den Ionenmischprozeß eine Monolage 4 aus Silizium-Nanoclustern erzeugt. Während der Ionenbestrahlung werden im Siliziumsubstrat 2 in der Lage 5 Kristallgitterschäden erzeugt, die bei der weiteren Verarbeitung der Siliziumsubstrate von Bedeutung sein können. Die Lage 5 befindet sich etwa dort, wo die Ionen zur Ruhe kommen (mittlere Reichweite der Ionen im Siliziumsubstrat) und liegt im vorliegenden Fall bei einer Tiefe von 0,5 µm bis 1,0 µm im Siliziumsubstrat 2.

Eine Modifikation des obigen Beispiels wird nachstehend beschrieben. Befindet sich - wie in Figur 2 dargestellt - auf der $SiO_2$-Schicht 1 mit der Dicke von ca. 100 nm eine Deckschicht 6 aus Silziumnitrid mit einer Dicke von 100 nm, so wird die Energie der Silizium-Ionen 3 auf entsprechend 500 keV bis 900 keV erhöht, um die beiden Schichten 1 und 6 vollständig zu durchstrahlen. Die Lage 5 mit Kristallgitterschäden im Siliziumsubstrat 2 liegt wieder in einer entsprechenden Silizium-Substrattiefe von 0,5 µm bis 1,0 µm. In Nähe der Grenzfläche der $SiO_2$-Schicht 1 zum Siliziumsubstrat 2 wird durch den Ionenmischprozeß auch in diesem Fall eine Monolage 7 aus Silizium-Nanoclustern erzeugt.

Besteht die Deckschicht 8 aus amorphem oder polykristallinem Silizium mit einer Dicke von 100 nm, so entsteht durch den Ionenmischprozeß in Nähe der beiden Grenzflächen der $SiO_2$-Schicht 1 zur amorphen oder polykristallinen Silizium-Deckschicht 8 und zum Siliziumsubstrat 2 neben der Monolage 7 eine weitere Monolage 9 aus Silizium-Nanoclustern.

In den Figuren 3 ist eine weitere Modifikation ausgeführt.

Die Durchstrahlung der $SiO_2$-Schicht 1 - hier Gateoxidschicht genannt - und einer polykristallinen Silizium-Deckschicht 8 - hier poly-Si-Gateelektrode genannt - einer MOS-Feldeffektransistor-Struktur erfolgt mit hochenergetischen Silizium-Ionen 3. Bei einer Schichtdicke des Gateoxids von größer als 15 nm werden in Nähe der beiden Grenzflächen zur poly-Si-Gateelektrode bzw. zum Siliziumsubstrat 2 zwei Monolagen 7 und 9 aus Silizium-Nanoclustern durch den Ionenmischprozeß erzeugt. Wird die Dicke der Gateoxidschicht 1 auf weniger als 10 nm reduziert, verschmelzen die beiden Monolagen 7 und 9 zu einer Monolage 10 aus Silizium-Nanoclustern, die sich ungefähr in der Mitte der $SiO_2$-Schicht und in hinreichender Nähe zur $SiO_2$/Si-Grenzfläche befindet.

Für MOS-Feldeffekttransistorstrukturen mit einer Gateoxiddicke von 5 nm bis 20 nm und einer Dicke der poly-Si-Gateelektrode von 300 nm findet die Durchstrahlung der $SiO_2$-Schicht mit Siliziumionen mit einer Energie von 0,7 MeV bis 1,0 MeV und einer Dosis von $(0,1...10,0) \cdot 10^{16}$ cm$^{-2}$ bei einer Temperatur der $SiO_2$-Schicht von 600 bis 800 °C statt. In Abhängigkeit von den technologischen Randbedingungen im Herstellungsprozeß von MOS-Feldeffekttransistoren kann der Verfahrensschritt mit praktisch unveränderten Prozeßparametern auch nach der Abscheidung der poly-Silizium-Deckschicht 8, noch vor der lithografischen Strukturierung der beiden Schichten 1 und 8 erfolgen. Bei Ionenbestrahlung nur der thermisch gewachsenen Gateoxid-Schicht 1 ohne Deckschicht kann die Ionenenergie auf 500 bis 700 keV reduziert werden.

Während der Ionenbestrahlung werden außerdem im Siliziumsubstrat 2 in der Lage 5 Kristallgitterschäden erzeugt. Die Lage 5 befindet sich etwa dort, wo die Silizium-Ionen 3 im Siliziumsubstrat 2 steckengeblieben sind. Die Kristallgitterschäden in der Tiefe des Siliziumsubstrats 2 können bei entsprechender Temperaturbehandlung vorhandene Verunreinigungen, besonders Schwermetalle, im Siliziumsubstrat 2 aus dem oberflächennahen Bereich des Siliziumsubstrats 2 gettern und somit die Funktionseigenschaften des MOS-Feleffekttransistorstruktur an der Oberfläche des Siliziumsubstrats 2 verbessern.

## Patentansprüche

1. Verfahren zur Herstellung von Monolagen aus Silizium-Nanoclustern in Siliziumdioxidschichten, **dadurch gekennzeichnet, daß** eine wenige Nanometer bis 100 nm dicke Siliziumdioxidschicht (1) auf einem Siliziumsubstrat (2) mit Ionen (3), vorzugsweise Sauerstoff-, Silizium- oder Germaniumionen, mit einer Ionenenergie von 10 keV bis 10 MeV und einer Ionendosis von $10^{15}$ bis $10^{18}$ cm$^{-2}$, bei einer Temperatur der Siliziumdioxidschicht (1) von 300 bis 800 °C durchstrahlt wird.

2. Verfahren nach Anspruch 1, **dadurch gekennzeichnet, daß** die Siliziumdioxidschicht (1) mit Silizium-Ionen (3) durchstrahlt wird, die die gleiche atomare Masse wie die Atome des Siliziumsubstrates (2) besitzen.

3. Verfahren nach Anspruch 1, **dadurch gekennzeichnet, daß** die Ionenbestrahlung der Siliziumdioxidschicht (1) durch eine oder mehrere darüberliegende dünne Deckschichten (6) erfolgt, wobei die Ionenenergie soweit erhöht wird, daß die Siliziumdioxidschicht (1) und die Deckschicht (6) durchstrahlt werden.

4. Verfahren nach Anspruch 1 und 3, **dadurch gekennzeichnet, daß** bei Ionenbestrahlung von poly-Silizium- und Siliziumdioxidschichten (1) auf Siliziumsubstrat (2) die Ionenenergie bei größer oder gleich 0,5 MeV gewählt wird.

5. Verfahren nach Anspruch 1, **dadurch gekennzeichnet, daß** die Ionenstromdichte und Ionenenergie während der Bestrahlung so gewählt werden, daß eine Ionenstrahl-induzierte Heizung des Siliziumsubstrates (2) und der Siliziumdioxidschicht (1) von 300 bis 800 °C erreicht wird.

## Claims

1. Method for making silicon nanocluster monolayers in silicon oxide layers, **characterized in that** one silicon oxide layer (1) with a thickness of a small number of nanometers up to 100 nm is irradiated on a silicon substrate (2) with ions (3), preferably oxygen, silicon or germanium ions, with an ion energy of 10 keV to 10 MeV and an ion dose of $10^{15}$ to $10^{18}$ cm$^{-2}$, the silicon oxide layer (1) having a temperature of 300 to 800°C.

2. Method according to claim 1, **characterized in that** the silicon oxide layer (1) is irradiated with silicon ions (3) that have the same atomic mass as the atoms of the silicon substrate (2).

3. Method according to claim 1, **characterized in that** the ion irradiation of the silicon oxide layer (1) takes place through one or more overlying thin covering layers (6), whereby the ion energy is increased until the silicon oxide layer (1) and the covering layer (6) are irradiated.

4. Method according to claim 1 and 3, **characterized in that** in the irradiation of poly-silicon and silicon oxide layers (1) on silicon substrate (2), the ion energy used is greater than or equal to 0.5 MeV.

5. Method according to claim 1, **characterized in that** the ion current density and ion energy used during the irradiation achieve ion current induced heating of the silicon substrate (2) and of the silicon oxide layer (1) between 300 and 800°C.

## Revendications

1. Procédé de fabrication d'une couche monomoléculaire de nanoclusters de silicium dans une couche de silice, **caractérisé en ce qu'**un petit nombre de nanomètres est irradié jusqu'à une couche de silice de 100 nm d'épaisseur (1) sur un substrat de silicium (2) avec des ions (3), de préférence des ions d'oxygène, de silicium ou de germanium, avec une énergie ionique de 10 keV à 10 MeV et une dose ionique de $10^{15}$ à $10^{18}$ cm$^{-2}$ à une température de la couche de silice (1) de 300 à 800 °C.

2. Procédé selon la revendication 1 **caractérisé en ce que** la couche de silice (1) est irradiée avec les ions de silicium (3) qui disposent de la même masse atomique que les atomes du substrat de silicium (2).

3. Procédé selon la revendication 1 **caractérisé en ce que** l'irradiation ionique de la couche de silice (1) s'effectue par une ou plusieurs couches couvrantes fines susjacentes (6) sachant que l'énergie ionique est augmentée jusqu'à ce que la couche de silice (1) et la couche couvrante (6) soient irradiées.

4. Procédé selon les revendications 1 et 3 **caractérisé en ce que** lors de l'irradiation ionique des couches de poly-silice et de silice (1) sur le substrat de silicium (2), l'énergie ionique choisie est de plus de ou égale à 0,5 MeV.

5. Procédé selon la revendication 1 **caractérisé en ce que** le densité de courant ionique et l'énergie ionique pendant l'irradiation sont choisies de manière à obtenir une température de chauffage, qui est induite par le rayon ionique, du substrat de silicium (2) et la couche de silice (1) de 300 à 800 °C.

# Figur 1

# Figur 2

a)

b)

c)

# Figur 3

a)

3
8
1
5
2

b)

8
9
1
7
5
2

c)

8
1
10
5
2